# EUROPEAN PATENT APPLICATION

(11) **EP 3 401 152 A1**
(43) Date of publication of application: **14.11.2018**
(21) Application number: 18157691.9
(22) Date of filing: 20.02.2018
(51) Int. Cl.: B60L 3/00

(54) **ELECTRIC VEHICLE AND ELECTROMAGNETIC INTERFERENCE SUPPRESSION CIRCUIT THEREOF**

(30) Priority: 24.02.2017 CN 201710103803
(71) Applicant: Optimum Battery Co., Ltd., Shenzhen City, Guangdong 518118 (CN)
(72) Inventor: LIU, Jun qi, Shenzhen, Guangdong 518118 (CN); ZHU, Ren Ping, Shenzhen, Guangdong 518118 (CN); HE, Wan, Shenzhen, Guangdong 518118 (CN)
(74) Representative: Greaves Brewster LLP

(57) **Abstract**

The present invention provides an electromagnetic interference suppression circuit including an isolation module, a transient high voltage suppression module, a common mode rejection module, and a filter module. The isolation module electrically isolates first signals to generate second signals. The transient high voltage suppression module protects the second signals against overvoltage spikes. The common mode rejection module protects the second signals against common mode noise. The filter module filters noise of the second signals, and protects the second signals against signal reflection at output terminals of the electromagnetic interference suppression circuit. The present invention further provides an electric vehicle including the electromagnetic interference suppression circuit.

## Description

### BACKGROUND OF THE INVENTION

### Field of the Invention

This invention relates to electric vehicles, and more particular, to an electric vehicle having an electromagnetic interference suppression circuit.

### Description of the Related Art

At present, each electric vehicle employs a large number of electronic components, such as, controllers, motors, and drivers. However, different electronic components may be made by different manufacturers with different versions, and different manufacturers and different versions of electronic components may lead to excessive electromagnetic compatibility. Therefore, electromagnetic interference in each electric vehicle may become serious, and a safe operation of each electric vehicle may be affected.

It is desirable to provide an invention, which can overcome the problems and limitations mentioned above.

### SUMMARY OF THE INVENTION

The present invention is directed to an electric vehicle and an electromagnetic interference suppression circuit of the electric vehicle that substantially obviates one or more of the problems due to limitations and disadvantages of the related art.

In an aspect of the present invention, there is provided an electromagnetic interference suppression circuit comprising an isolation module, a transient high voltage suppression module, a common mode rejection module, and a filter module. The isolation module is configured to electrically isolate first signals to generate second signals. The transient high voltage suppression module is configured to protect the second signals against overvoltage spikes. The common mode rejection module is configured to protect the second signals against common mode noise. The filter module is configured to filter noise of the second signals, and protect the second signals against signal reflection at output terminals of the electromagnetic interference suppression circuit.

In another aspect of the present invention, there is provided an electric vehicle comprising an electromagnetic interference suppression circuit. The electromagnetic interference suppression circuit comprises an isolation module, a transient high voltage suppression module, a common mode rejection module, and a filter module. The isolation module is configured to electrically isolate first signals to generate second signals. The transient high voltage suppression module is configured to protect the second signals against overvoltage spikes. The common mode rejection module is configured to protect the second signals against common mode noise. The filter module is configured to filter noise of the second signals, and protect the second signals against signal reflection at output terminals of the electromagnetic interference suppression circuit.

It is to be understood that both the foregoing general description and the following detailed description are exemplary and explanatory and are intended to provide further explanations of the invention as claimed.

### BRIEF DESCRIPTION OF THE DRAWINGS

Implementations of the present technology will now be described, by way of example only, with reference to the attached drawings. It may be understood that these drawings are not necessarily drawn to scale, and in no way limit any changes in form and detail that may be made to the described embodiments by one skilled in the art without departing from the spirit and scope of the described embodiments.
FIG. 1 is a block schematic diagram of an electric vehicle provided by an embodiment of the present invention, wherein the electric vehicle comprises an electromagnetic interference suppression circuit.
FIG. 2 is a block schematic diagram of the electromagnetic interference suppression circuit of FIG. 1 provided by an embodiment of the present invention.
FIG. 3 is a circuit diagram of the electromagnetic interference suppression circuit of FIG. 1 provided by an embodiment of the present invention.
FIG. 4 is a circuit diagram of the electromagnetic interference suppression circuit of FIG. 1 provided by another embodiment of the present invention.

### DETAILED DESCRIPTION OF THE PREFERRED EMBODIMENTS

In order to make the purposes, technical solutions, and advantages of the present invention be clearer, the present invention will be further described in detail hereafter with reference to the accompanying drawings and embodiments. However, it will be understood by those of ordinary skill in the art that the embodiments described herein can be practiced without these specific details. In other instances, methods, procedures and components have not been described in detail so as not to obscure the related relevant feature being described. Also, it should be understood that the embodiments described herein are only intended to illustrate but not to limit the present invention.

Several definitions that apply throughout this disclosure will be presented. The term "coupled" is defined as connected, whether directly or indirectly through intervening components, and is not necessarily limited to physical connections. The connection can be such that the objects are permanently connected or releasably connected. The term "comprise", when utilized, means "include, but not necessarily limited to"; it specifically indicates open-ended inclusion or membership in a so-described combination, group, series and the like.

It should be noted that references to "an" or "one" embodiment in this disclosure are not necessarily to the same embodiment, and such references mean "at least one."

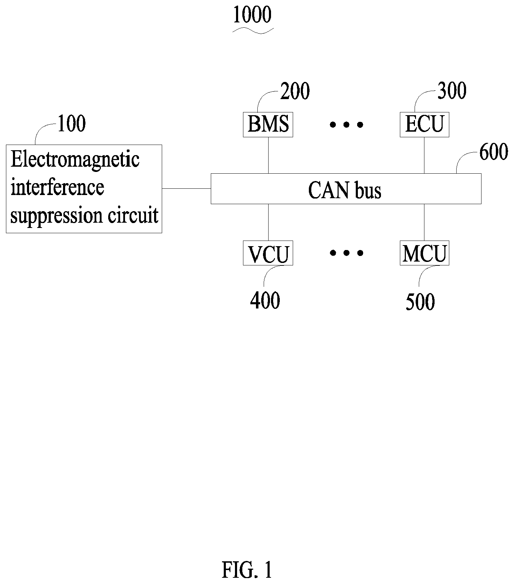

Fig. 1 illustrates a block schematic diagram of an electric vehicle 1000 provided by an embodiment of the present invention. The electric vehicle 1000 comprises an electromagnetic interference suppression circuit 100, a battery management system (BMS) 200, an electronic control unit (ECU) 300, a vehicle control unit (VCU) 400, a motor control unit (MCU) 500, and a controller area network (CAN) bus 600. The CAN bus 600 is electrically coupled to the electromagnetic interference suppression circuit 100, the BMS 200, the ECU 300, the VCU 400, and the MCU 500. The BMS 200, the ECU 300, the VCU 400, and the MCU 500 are communicated to each other through the CAN bus 600.

It may be understood that, the electric vehicle 1000 can comprise other electronic components, such as, drivers, direct current (DC) to DC converters, electrically coupled to the CAN bus 600. Each electronic component is communicated to the BMS 200, the ECU 300, the VCU 400, the MCU 500, and other components through the CAN bus 600.

It may be understood that, the BMS 200, the ECU 300, the VCU 400, the MCU 500, and the electronic components may be made by different manufacturers with different versions, and electromagnetic compatibility of the BMS 200, the ECU 300, the VCU 400, the MCU 500, and the electronic components may be excessed. Electromagnetic interference in the electric vehicle 1000 may be serious, signals transmitted in the CAN bus 600 may be affected, and a safe operation of the electric vehicle 1000 may be affected accordingly.

The electromagnetic interference suppression circuit 100 is employed in the electric vehicle 1000, to protect the CAN bus 600 against electromagnetic interference. Therefore, signals transmitted in the CAN bus 600 can maintain high quality, and operation safety of the electric vehicle 1000 can be improved.

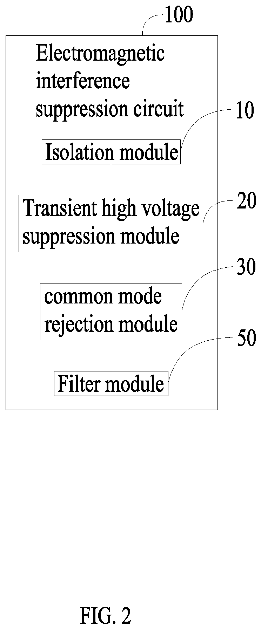

Please refer to Figs.2-4, the electromagnetic interference suppression circuit 100 comprises an isolation module 10, a transient high voltage suppression module 20, a common mode rejection module 30, and a filter module 50/50'. The transient high voltage suppression module 20 is electrically coupled to the isolation module 10, and electrically coupled to the filter module 50/50' through the common mode rejection module 30.

The isolation module 10 is configured to electrically isolate first signals S11 and S12 to generate second signals S21 and S22. The transient high voltage suppression module 20 is configured to protect the second signals S21 and S22 against overvoltage spikes. The common mode rejection module 30 is configured to protect the second signals S21 and S22 against common mode noise. The filter module 50/50' is configured to filter noise of the second signals S21 and S22, and protect the second signals S21 and S22 against signal reflection at output terminals O1 and O2 of the electromagnetic interference suppression circuit 100.

The isolation module 10 comprises an isolation chip IC1. The isolation chip IC1 comprises two input pins 2 and 3, a first output pin 7, a second output pin 6, a first power pin 1, a second power pin 8, and two ground pins 4 and 5. The two input pins 2 and 3 are configured to receive the first signals S11 and S12. The first output pin 7 and the second output pin 6 are configured to output the second signals S21 and S22 to the transient high voltage suppression module 20 and the common mode rejection module 30. The first power pin 1 is electrically coupled to a first power supply V1. The second power pin 8 is electrically coupled to a second power supply V2. The two ground pins 4 and 5 are electrically coupled to ground. In an embodiment, the isolation chip IC1 is an optocoupler.

The common mode rejection module 30 comprises a common mode rejection element IC2. The common mode rejection element IC2 comprises a first input terminal 1, a second input terminal 2, a first output terminal 3, and a second output terminal 4. The first input terminal 1 of the common mode rejection element IC2 is electrically coupled to the first output pin 7 of the isolation chip IC1. The second input terminal 2 of the common mode rejection element IC2 is electrically coupled to the second output pin 6 of the isolation chip IC1. The first output terminal 3 of the common mode rejection element IC2 is electrically coupled to the filter module 50/50'. The second output terminal 4 of the common mode rejection element IC2 is electrically coupled to the filter module 50/50'. In an embodiment, the common mode rejection element IC2 is a common mode inductor.

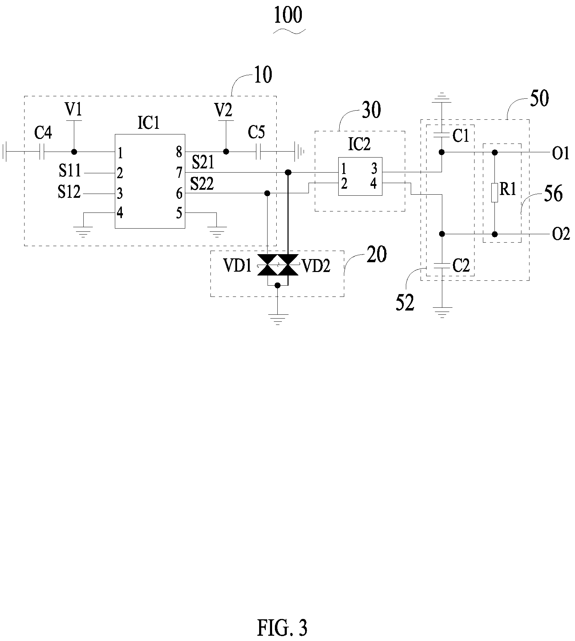

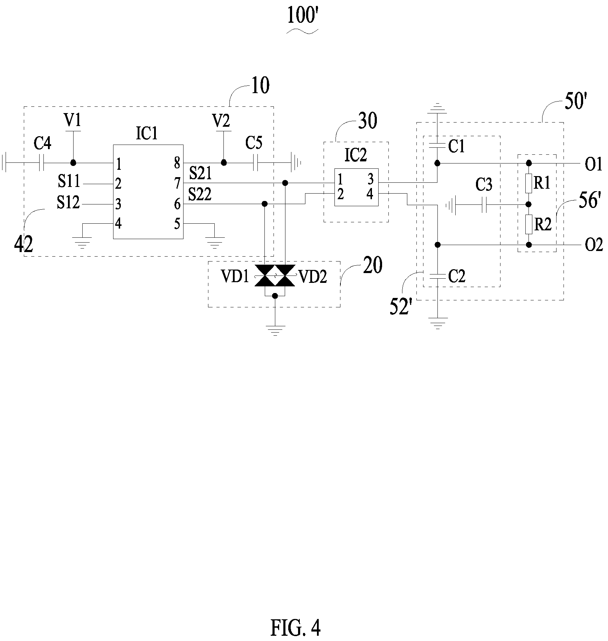

Please refer to Fig.3 and Fig.4, the filter module 50/50' comprises a filter unit 52/52' and a signal reflection suppression unit 56/56'. The filter unit 52/52' is configured to filter noise of the second signals S21 and S22. The signal reflection suppression unit 56/56' is configured to protect the second signals S21 and S22 against signal reflection at the output terminals O1 and O2 of the electromagnetic interference suppression circuit 100.

In an embodiment, as shown in Fig.3, the filter unit 52 comprises a first capacitor C1 and a second capacitor C2, and the signal reflection suppression unit 56 comprises a first resistor R1. The first resistor R1 comprises a first terminal and a second terminal. The first terminal of the first resistor R1 functions as one of the output terminals O1 and O2 of the electromagnetic interference suppression circuit 100, is electrically coupled to the first output terminal 3 of the common mode rejection element IC2, and is electrically coupled to ground through the first capacitor C1. The second terminal of the first resistor R1 functions as another one of the output terminals O1 and O2 of the electromagnetic interference suppression circuit 100, is electrically coupled to the second output terminal 4 of the common mode rejection element IC2, and is electrically coupled to ground through the second capacitor C2.

In another embodiment, as shown in Fig.4, the filter unit 52' comprises a first capacitor C1, a second capacitor C2, and a third capacitor C3. The signal reflection suppression unit 56' comprises a first resistor R1 and a second resistor R2. The first resistor R1 comprises a first terminal and a second terminal. The second resistor R2 comprises a first terminal and a second terminal. The first terminal of the first resistor R1 functions as one of the output terminals O1 and O2 of the electromagnetic interference suppression circuit 100, is electrically coupled to the first output terminal 3 of the common mode rejection element IC2, and is electrically coupled to ground through the first capacitor C1. The first terminal of the second resistor R2 functions as another one of the output terminals O1 and O2 of the electromagnetic interference suppression circuit 100, is electrically coupled to the second output terminal 4 of the common mode rejection element IC2, and is electrically coupled to ground through the second capacitor C2. The second terminal of the second resistor R2 is electrically coupled to the second terminal of the first resistor R1, and is electrically ground through the third capacitor C3.

The transient high voltage suppression module 20 comprises a first transient voltage suppressor (TVS) VD1 and a second TVS VD2. The first TVS VD1 comprises a first terminal electrically coupled to the first output pin 7 of the isolation chip IC1, and a second terminal electrically coupled to ground. The second TVS VD2 comprises a first terminal electrically coupled to the second output pin 6 of the isolation chip IC1, and a second terminal electrically coupled to ground.

In an embodiment, the isolation module 10 further comprises a fourth capacitor C4 and a fifth capacitor C5. The fourth capacitor C4 comprises a first terminal electrically coupled to the first power supply V1, and a second terminal electrically coupled to ground. The fifth capacitor C5 comprises a first terminal electrically coupled to the second power supply V2, and a second terminal electrically coupled to ground. The fourth capacitor C4 is configured to filter noise of the first power supply V1, and the fifth capacitor C5 is configured to filter noise of the second power supply V2.

An operation principle of the electric vehicle 1000 and the electromagnetic interference suppression circuit 100 provided by an embodiment of the present invention will be described below.

In operation, the BMS 200, the ECU 300, the VCU 400, the MCU 500, and other electronic components are communicated to each other through the CAN bus 600. The two input pins 2 and 3 of the isolation chip IC1 receive the first signals S11 and S12 from the CAN bus 600. The first signals S11 and S12 are electrically isolated by the isolation chip IC1, to generate the second signals S21 and S22. The first output pin 7 and the second output pin 6 of the isolation chip IC1 output the second signals S21 and S22 to the transient high voltage suppression module 20 and the common mode rejection module 30. The transient high voltage suppression module 20 protects the second signals S21 and S22 against overvoltage spikes. The common mode rejection module 30 protects the second signals S21 and S22 against common mode noise. The filter module 50/50' filters noise of the second signals S21 and S22, protects the second signals S21 and S22 against signal reflection at the output terminals O1 and O2 of the electromagnetic interference suppression circuit 100, and outputs the second signals S21 and S22 from the output terminals O1 and O2 of the electromagnetic interference suppression circuit 100.

That is, the electromagnetic interference suppression circuit 100 can protect the CAN bus 600 against electromagnetic interference. Therefore, signals transmitted in the CAN bus 600 can maintain high quality, and operation safety of the electric vehicle 1000 can be improved.

It may be understood that, the output terminals O1 and O2 of the electromagnetic interference suppression circuit 100 can be electrically coupled to the CAN bus 600, the BMS 200, the ECU 300, the VCU 400, the MCU 500, or other electronic components, to output the second signals S21 and S22 to the CAN bus 600, the BMS 200, the ECU 300, the VCU 400, the MCU 500, or other electronic components.

It may be understood that, the electromagnetic interference suppression circuit 100 can be electrically coupled to other electronic components of the electric vehicle 1000, such as, drivers, to protect other electronic components of the electric vehicle 1000 against electromagnetic interference.

It may be understood that, the electromagnetic interference suppression circuit 100 can be applied in other electronic devices, such as, smart phones, computers, servers, to protect other electronic devices against electromagnetic interference.

As detailed above, the isolation module 10 electrically isolates the first signals S11 and S12 received from the CAN bus 600 to generate second signals S21 and S22; the transient high voltage suppression module 20 protects the second signals S21 and S22 against overvoltage spikes; the common mode rejection module 30 protects the second signals S21 and S22 against common mode noise; and the filter module 50/50' filters noise of the second signals S21 and S22, protects the second signals S21 and S22 against signal reflection at the output terminals O1 and O2 of the electromagnetic interference suppression circuit 100. Therefore, the electromagnetic interference suppression circuit 100 can protect the CAN bus 600 against electromagnetic interference, signals transmitted in the CAN bus 600 can maintain high quality, and operation safety of the electric vehicle 1000 can be improved.

It will be apparent to those skilled in the art that various modification and variations can be made in the multicolor illumination device and related method of the present invention without departing from the SPI 16rit or scope of the invention. Thus, it is intended that the present invention cover modifications and variations that come within the scope of the appended claims and their equivalents.

## Claims

1. An electromagnetic interference suppression circuit (100), comprising:
an isolation module (10) configured to electrically isolate first signals (S11 and S12) to generate second signals (S21 and S22);
a transient high voltage suppression module (20) configured to protect the second signals (S21 and S22) against overvoltage spikes;
a common mode rejection module (30) configured to protect the second signals (S21 and S22) against common mode noise; and
a filter module (50/50') configured to filter noise of the second signals (S21 and S22), and protect the second signals (S21 and S22) against signal reflection at output terminals (O1 and O2) of the electromagnetic interference suppression circuit (100).

2. The electromagnetic interference suppression circuit (100) of claim 1, wherein the isolation module (10) comprises an isolation chip (IC1) comprising:
two input pins (2 and 3) configured to receive the first signals (S11 and S12);
a first output pin (7) and a second output pin (6) configured to output the second signals (S21 and S22) to the transient high voltage suppression module (20) and the common mode rejection module (30);
a first power pin (1) electrically coupled to a first power supply (V1);
a second power pin (8) electrically coupled to a second power supply (V2); and
two ground pins (4 and 5) electrically coupled to ground.

3. The electromagnetic interference suppression circuit (100) of claim 2, wherein the common mode rejection module (30) comprises a common mode rejection element (IC2) comprising:
a first input terminal (1) electrically coupled to the first output pin (7) of the isolation chip (IC1);
a second input terminal (2) electrically coupled to the second output pin (6) of the isolation chip (IC1);
a first output terminal (3) electrically coupled to the filter module (50/50'); and
a second output terminal (4) electrically coupled to the filter module (50/50').

4. The electromagnetic interference suppression circuit (100) of claim 3, wherein the filter module (50/50') comprises:
a filter unit (52/52') configured to filter noise of the second signals (S21 and S22); and
a signal reflection suppression unit (56/56') configured to protect the second signals (S21 and S22) against signal reflection at the output terminals (O1 and O2) of the electromagnetic interference suppression circuit (100).

5. The electromagnetic interference suppression circuit (100) of claim 4, wherein the filter unit (52) comprises a first capacitor (C1) and a second capacitor (C2), and the signal reflection suppression unit (56) comprises a first resistor (R1) comprising:
a first terminal functioning as one of the output terminals (O1 and O2) of the electromagnetic interference suppression circuit (100), electrically coupled to the first output terminal (3) of the common mode rejection element (IC2), and electrically coupled to ground through the first capacitor (C1); and
a second terminal functioning as another one of the output terminals (O1 and O2) of the electromagnetic interference suppression circuit (100), electrically coupled to the second output terminal (4) of the common mode rejection element (IC2), and electrically coupled to ground through the second capacitor (C2).

6. The electromagnetic interference suppression circuit (100) of claim 4, wherein the filter unit (52') comprises a first capacitor (C1), a second capacitor (C2), and a third capacitor (C3); and the signal reflection suppression unit (56') comprises:
a first resistor (R1) comprising a first terminal functioning as one of the output terminals (O1 and O2) of the electromagnetic interference suppression circuit (100), electrically coupled to the first output terminal (3) of the common mode rejection element (IC2), and electrically coupled to ground through the first capacitor (C1), and a second terminal; and
a second resistor (R2) comprising a first terminal functioning as another one of the output terminals (O1 and O2) of the electromagnetic interference suppression circuit (100), electrically coupled to the second output terminal (4) of the common mode rejection element (IC2), and electrically coupled to ground through the second capacitor (C2), and a second terminal electrically coupled to the second terminal of the first resistor (R1), and electrically ground through the third capacitor (C3).

7. The electromagnetic interference suppression circuit (100) of claim 2, wherein the transient high voltage suppression module (20) comprises:
a first transient voltage suppressor (TVS) (VD1) comprising a first terminal electrically coupled to the first output pin (7) of the isolation chip (IC1), and a second terminal electrically coupled to ground; and
a second TVS (VD2) comprising a first terminal electrically coupled to the second output pin (6) of the isolation chip (IC1), and a second terminal electrically coupled to ground.

8. The electromagnetic interference suppression circuit (100) of claim 2, wherein the isolation module (10) further comprises:
a fourth capacitor (C4) comprising a first terminal electrically coupled to the first power supply (V1), and a second terminal electrically coupled to ground; and
a fifth capacitor (C5) comprising a first terminal electrically coupled to the second power supply (V2), and a second terminal electrically coupled to ground;
wherein the fourth capacitor (C4) is configured to filter noise of the first power supply (V1), and the fifth capacitor (C5) is configured to filter noise of the second power supply (V2).

9. An electric vehicle (1000), comprising:
an electromagnetic interference suppression circuit (100) comprising:
an isolation module (10) configured to electrically isolate first signals (S11 and S12) to generate second signals (S21 and S22);
a transient high voltage suppression module (20) configured to protect the second signals (S21 and S22) against overvoltage spikes;
a common mode rejection module (30) configured to protect the second signals (S21 and S22) against common mode noise; and
a filter module (50/50') configured to filter noise of the second signals (S21 and S22), and protect the second signals (S21 and S22) against signal reflection at output terminals (O1 and O2) of the electromagnetic interference suppression circuit (100).

10. The electric vehicle (1000) of claim 9, wherein the isolation module (10) comprises an isolation chip (IC1) comprising:
two input pins (2 and 3) configured to receive the first signals (S11 and S12);
a first output pin (7) and a second output pin (6) configured to output the second signals (S21 and S22) to the transient high voltage suppression module (20) and the common mode rejection module (30);
a first power pin (1) electrically coupled to a first power supply (V1);
a second power pin (8) electrically coupled to a second power supply (V2); and
two ground pins (4 and 5) electrically coupled to ground.

11. The electric vehicle (1000) of claim 10, wherein the common mode rejection module (30) comprises a common mode rejection element (IC2) comprising:
a first input terminal (1) electrically coupled to the first output pin (7) of the isolation chip (IC1);
a second input terminal (2) electrically coupled to the second output pin (6) of the isolation chip (IC1);
a first output terminal (3) electrically coupled to the filter module (50/50'); and
a second output terminal (4) electrically coupled to the filter module (50/50').

12. The electric vehicle (1000) of claim 11, wherein the filter module (50/50') comprises:
a filter unit (52/52') configured to filter noise of the second signals (S21 and S22); and
a signal reflection suppression unit (56/56') configured to protect the second signals (S21 and S22) against signal reflection at the output terminals (O1 and O2) of the electromagnetic interference suppression circuit (100).

13. The electric vehicle (1000) of claim 12, wherein the filter unit (52) comprises a first capacitor (C1) and a second capacitor (C2), and the signal reflection suppression unit (56) comprises a first resistor (R1) comprising:
a first terminal functioning as one of the output terminals (O1 and O2) of the electromagnetic interference suppression circuit (100), electrically coupled to the first output terminal (3) of the common mode rejection element (IC2), and electrically coupled to ground through the first capacitor (C1); and
a second terminal functioning as another one of the output terminals (O1 and O2) of the electromagnetic interference suppression circuit (100), electrically coupled to the second output terminal (4) of the common mode rejection element (IC2), and electrically coupled to ground through the second capacitor (C2).

14. The electric vehicle (1000) of claim 12, wherein the filter unit (52') comprises a first capacitor (C1), a second capacitor (C2), and a third capacitor (C3); and the signal reflection suppression unit (56') comprises:
a first resistor (R1) comprising a first terminal functioning as one of the output terminals (O1 and O2) of the electromagnetic interference suppression circuit (100), electrically coupled to the first output terminal (3) of the common mode rejection element (IC2), and electrically coupled to ground through the first capacitor (C1), and a second terminal; and
a second resistor (R2) comprising a first terminal functioning as another one of the output terminals (O1 and O2) of the electromagnetic interference suppression circuit (100), electrically coupled to the second output terminal (4) of the common mode rejection element (IC2), and electrically coupled to ground through the second capacitor (C2), and a second terminal electrically coupled to the second terminal of the first resistor (R1), and electrically ground through the third capacitor (C3).

15. The electric vehicle (1000) of claim 10, wherein the transient high voltage suppression module (20) comprises:
a first transient voltage suppressor (TVS) (VD1) comprising a first terminal electrically coupled to the first output pin (7) of the isolation chip (IC1), and a second terminal electrically coupled to ground; and
a second TVS (VD2) comprising a first terminal electrically coupled to the second output pin (6) of the isolation chip (IC1), and a second terminal electrically coupled to ground.
